# EUROPEAN PATENT APPLICATION

(11) **EP 2 650 928 A1**
(43) Date of publication of application: **16.10.2013**
(21) Application number: 11847296.8
(22) Date of filing: 09.12.2011
(51) Int. Cl.: H01L 31/042

(54) **SOLAR CELL MODULE, AND METHOD OF MANUFACTURING SOLAR CELL MODULE**

(30) Priority: 09.12.2010 JP 2010274844
(71) Applicant: Dexerials Corporation, Tokyo 141-0032 (JP)
(72) Inventor: HANAI, Daisuke, Tokyo 141-0032 (JP); HIGUCHI, Akifumi, Tokyo 141-0032 (JP)
(74) Representative: Müller - Hoffmann & Partner
(86) International application number: PCT/JP2011/078552
(87) International publication number: WO 2012/077784

(57) **Abstract**

The present invention provides a solar cell module with a tab wire, which can maintain a desirable shaped state and can also obtain sufficient connection reliability with the tab wire, and a method of manufacturing such a solar cell module. The tab wire (3) is designed such that on both of the surface and the rear surface thereof, a plurality of convex portions and concave portions, which continue in the longitudinal direction, are alternately formed in the width direction so that concavo-convex portions (21) are formed thereon, and its one end is connected to a busbar electrode (11) serving as a surface electrode, while the other end is connected to a rear surface electrode (13), respectively via an adhesive resin material. Moreover, the tab wire (3) is also designed such that a concavo-convex angle, which is made by a line segment formed by connecting an apex of the convex portion and an apex of each of concave portions adjacent to the convex portion and a line segment formed by connecting the apexes of the concave portions adjacent to the two sides of the convex portion, is set to 10° or more to 50° or less.

## Description

### Field of the Invention

This invention relates to a solar cell module in which connection-use electrodes of a plurality of solar cells are electrically connected with one after another with tab wires, and a method of manufacturing such a solar cell module.
The present application asserts priority rights based on JP Patent Application 2010-274844 filed in Japan on December 9, 2010. The total contents of disclosure of the Patent Application of the senior filing date are to be incorporated by reference into the present Application.

### Background of the Invention

In general, a solar battery is utilized as a solar cell module in which a plurality of solar cells are series-connected with one after another so that an output of 100 W or more is achieved.

In a crystal silicon-based solar cell module, a plurality of adjacent solar cells are connected to one after another by tab wires made of a conductive material, such as a ribbon-shaped copper foil or the like, that are solder-coated as interconnectors. Each tab wire has its one end connected to a surface electrode of a solar cell, with the other end being connected to the rear surface electrode of an adjacent solar cell, so that the respective solar cells are series-connected to one after another.

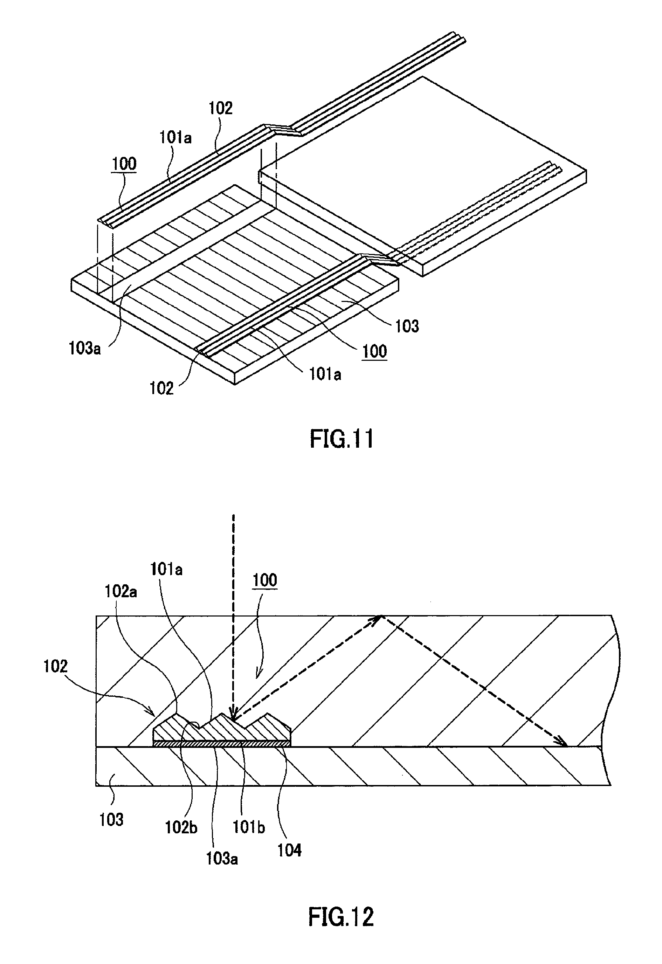

In recent years, as the tab wire, such a tab wire with one of surfaces on which concavo-convex portions are formed has been proposed. For example, as shown in Fig. 11, the tab wire 100 is formed into an elongated shape, with its surface 101a on the light-receiving side having concavo-convex portions 102 formed thereon. As shown in Fig. 12, the concavo-convex portions 102 are composed of a plurality of convex portions 102a and concave portions 102b, which respectively continue in a longitudinal direction of the tab wire 100, are alternately formed in a width direction.

Moreover, the tab wire 100 has its rear surface 101b connected to the surface electrode 103a of the solar cell 103 via a conductive adhesive film 104. Thus, since the solar cell 103 has its concavo-convex portions 102 directed toward the light-receiving surface side, an incident light ray is scattered by the concavo-convex portions 102. Then, the scattered light is reflected by the protection glass surface, and allowed to be again made incident on the light-receiving surface. With this arrangement, the solar cell module provided with the tab wire 100 is allowed to exert a light confinement effect to increase the power generation effect so that the power generation effect can be subsequently improved.

Patent Literature 1 has described a structure of a solar cell module provided with strings formed by arranging a plurality of solar cells in series with one after another by using tab wires each having such a surface on which concavo-convex portions are formed on the light-receiving side.

On the other hand, Patent Literature 2 has described a solar cell module provided with a tab wire having a surface on the side opposed to a connection-use electrode on which concavo-convex portions are formed. The convex portions of the tab wire described in Patent Literature 2 is made in contact with the connection-use electrode, with a conductive resin material being filled between the tab wire and the connection-use electrode. Thus, by raising the height of the concavo-convex portions, it becomes possible to improve the connection reliability (adhesion strength) of the tab wire.

### Prior-Art Documents

### Patent Document

PTL 1: Japanese Patent Application Laid-Open No. 2010-16300
PTL 2: Japanese Patent Application Laid-Open No. 2008-147567

### Summary of the Invention

As described above, in a solar cell in which tab wires, each having one of surfaces on which concavo-convex portions are formed, with the other surface on the opposite side being formed into a planar shape, are formed on a surface electrode as well as on a rear surface electrode, a difference in pressures to be applied onto the surface and the rear surface tends to occur upon adhesion of the tab wires. For this reason, in the solar cell, a stress distortion tends to occur between the surface electrode side and the rear surface electrode side. The generation of a stress distortion might cause cracks and warping in the solar cell.

In this case, in the crystal silicon-based solar cell, a main subject is to prepare a large amount of silicon serving as a raw material at low prices, and in recent years, from a polycrystalline silicon ingot, very thin silicon wafers (for example, 200µm to 150µm) are cut out and these have been started to be utilized for mass production. In these very thin solar cells, cracks and warping due to a stress distortion tend to more easily occur.

Moreover, in the tab wire, planar shaped surfaces that are respectively opposed to the surface electrode and the rear surface electrode might not be respectively connected to the surface electrode and the rear surface with sufficient adhesion strength.

In view of these conventional circumstances, the present invention has been devised, and its object is to provide a solar cell module that can maintain a desirable shaped state of the solar cell and can also obtain sufficient connection reliability with the tab wire, and a method of manufacturing such a solar cell module.

In order to solve the above-mentioned problems, the solar cell module of the present invention is provided with: a plurality of solar cells in which a surface electrode of a predetermined one of the solar cells is connected to a rear surface electrode of another one of the solar cells that is adjacent to one side of the predetermined solar cell via a tab wire, and in this structure, the tab wire has two surface and rear surface on which concavo-convex portions, which are composed of a plurality of convex portions and concave portions that respectively continue in a longitudinal direction, are alternately formed in a width direction, with one end thereof being connected to the surface electrode and the other end being connected to the rear surface electrode, respectively via an adhesive resin material, and a concavo-convex angle, which is made by a line segment formed by connecting an apex of the convex portion and an apex of each of concave portions adjacent to the convex portion and a line segment formed by connecting the apexes of the concave portions adjacent to the two sides of the convex portion, is set to 10° or more to 50° or less.

Moreover, in order to solve the above-mentioned problems, the method of manufacturing a solar cell module that includes a plurality of solar cells in which a surface electrode of a predetermined one of the solar cells is connected to a rear surface electrode of another one of the solar cells that is adjacent to one side of the predetermined solar cell via a tab wire, is provided with the step of: press-bonding the tab wire respectively onto the surface electrode and the rear surface electrode of the solar cell via an adhesive resin material, and in this method, the tab wire has two surface and rear surface on which concavo-convex portions, which are composed of a plurality of convex portions and concave portions that respectively continue in a longitudinal direction, are alternately formed in a width direction, and a concavo-convex angle, which is made by a line segment formed by connecting an apex of the convex portion and an apex of each of concave portions adjacent to the convex portion and a line segment formed by connecting the apexes of the concave portions adjacent to the two sides of the convex portion, is set to 10° or more to 50° or less, and in the press-bonding step, one end of the tab wire is connected to the surface electrode and the other end of the tab wire is connected to the rear surface electrode respectively, via the adhesive resin material.

In accordance with the present invention, by preventing a distortion from occurring in a solar cell, it is possible to maintain a desirable shaped state, and also to achieve sufficient connection reliability between a tab wire and the solar cell.

### Brief Description of Drawings

Figure 1 is an exploded perspective view showing a structure of a solar cell module.
Figure 2 is a cross-sectional view in a longitudinal direction showing strings of a solar cell.
Figure 3 is a perspective view showing solar cells connected by tab wires.
Figure 4 is a cross-sectional view of the solar cell.
Figure 5 is a cross-sectional view in a width direction of the tab wire.
Figure 6 is a cross-sectional view in a width direction of a conductive adhesive film.
Figure 7 is a schematic view showing one example of a mode of the conductive adhesive film.
Figure 8 is a schematic view for use in explaining a temporary press-bonding process of tab wires.
Figure 9 is a schematic view for use in explaining a main press-bonding process of tab wires.
Figure 10 is a cross-sectional view of a solar cell.
Figure 11 is a perspective view showing solar cells connected by using conventional tab wires.
Figure 12 is a cross-sectional view in a width direction of the conventional tab wire.

### Detailed Description of the Invention

Referring to Figures, the following description will discuss embodiments of the present invention (hereinafter, referred to as "present embodiment") in detail.

### [Solar Cell Module]

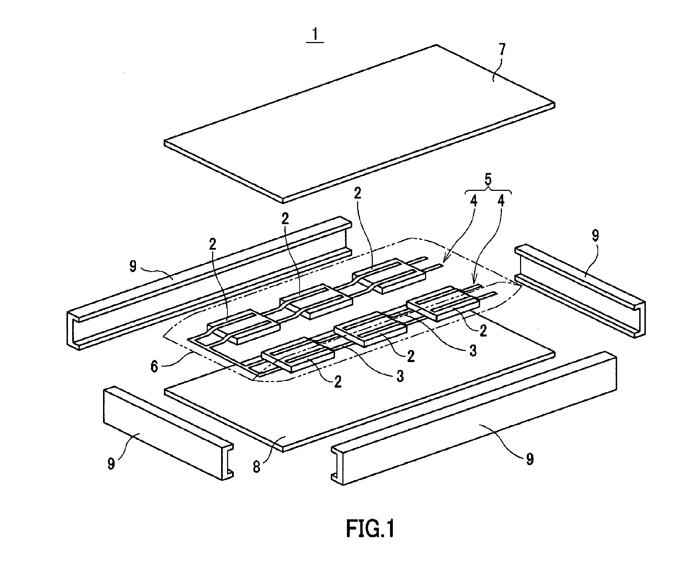

Fig. 1 is an exploded perspective view showing a structure of a solar cell module 1 provided with tab wires to which the present invention is applied. The solar cell module 1 is provided with strings 4 each of which is composed of a plurality of solar cells 2 that are connected in series with one after another by using tab wires 3 serving as interconnectors, and a matrix 5 formed by arranging a plurality of these strings 4.

The solar module 1 is formed through processes in which the matrix 5 is sandwiched by sheets 6 made of a sealing adhesive agent, and laminated together with a surface cover 7 formed on a light receiving surface side and a back sheet 8 formed on a rear surface side as one lot, and a metal frame 9 made of aluminum or the like is attached on the peripheral portion thereof.

As the sealing adhesive agent for the sheets 6, for example, a translucent sealing material, such as an ethylene vinyl acetate resin (EVA) or the like, is used. As the surface cover 7, for example, a translucent material, such as glass or a translucent plastic material, is used. As the back sheet 8, a laminate member or the like in which glass or an aluminum foil is sandwiched by resin films is used.

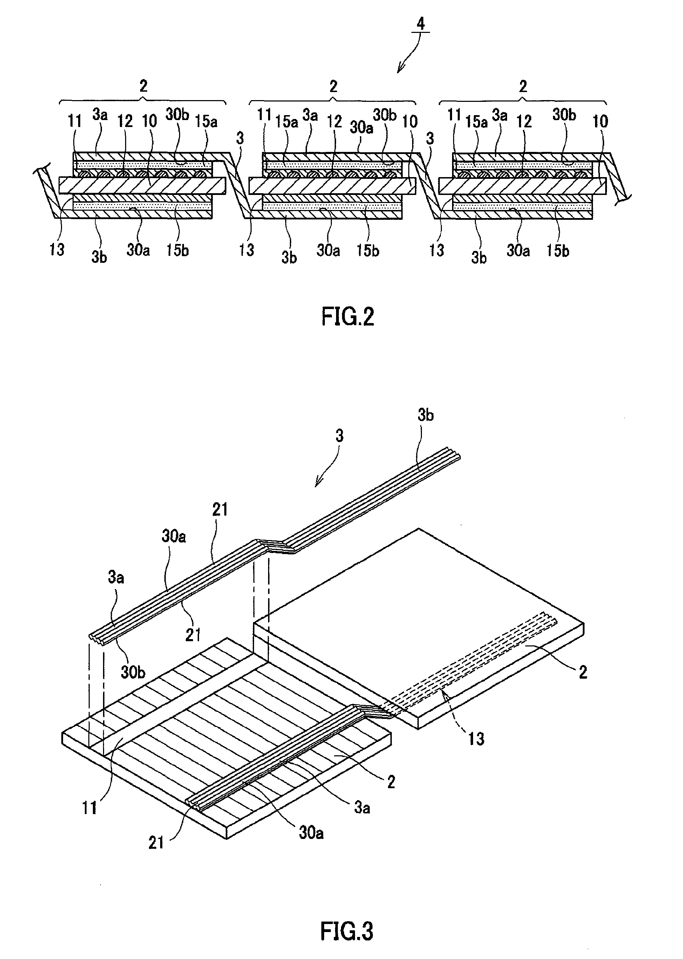

Fig. 2 is a cross-sectional view in a longitudinal direction of a strings 4 formed by connecting solar battery cells 2 in series with one after another. Each solar cell 2 is provided with a photoelectric conversion element 10. As the photoelectric conversion element 10, various kinds of photoelectric conversion elements 10, such as a crystal silicon-based solar cell module using a single crystal-type silicon photoelectric conversion element or a polycrystal-type photoelectric conversion element, and a thin-film silicon-based solar cell using a photoelectric conversion element in which a cell made of amorphous silicon and a cell made of microcrystal silicon and amorphous silicon germanium are stacked on each other, may be used.

Moreover, on a light-receiving surface of the photoelectric conversion element 10, bus bar electrodes 11 and finger electrodes 12 that are collector electrodes formed in a direction virtually orthogonal to the bus bar electrodes 11 are installed as surface electrodes. Furthermore, on the surface opposite to the light-receiving surface of the photoelectric conversion element 10, a rear surface electrode 13 made of aluminum, silver or the like is installed.

With respect to the mutual solar cells 2, the busbar electrodes 11 of a predetermined solar cell 2 are electrically connected to the rear surface electrode 13 of an adjacent solar cell 2 by the tab wire 3 so that strings 4 are formed.

More specifically, at one end 3a of the tab wire 3, one surface 30b of the tab wire 3 is connected to the busbar electrodes 11 of the solar cell 2 via a conductive adhesive film 15a. Moreover, at the other end 3b of the tab wire 3, the other surface 30a of the tab wire 3 is connected to a rear surface electrode 13 of an adjacent solar cell 2 on the one side via a conductive film 15b.

The finger electrodes 12 are formed through processes in which, after an Ag paste has been applied thereon, a baking process is carried out thereon. The finger electrodes 12 are formed virtually over the entire surface of the light-receiving surface of the solar cell 2. Moreover, the finger electrodes 12 are formed as lines, each having a width of, for example, about 100µm, that are placed at predetermined intervals, that is, for example, every other 2 mm.

The busbar electrodes 11 are formed by using the same method as that of the finger electrodes 12. In order to make the area shielding incident light smaller and to suppress the shadow loss, the busbar electrodes 11 are formed on the surface of the photoelectric conversion element 10 serving as a light-receiving surface of each solar cell 2, as a line having a width of, for example, 1 mm, so as to cross the busbar electrodes 11.

The number of the busbar electrodes 11 is determined on demand by taking account of the size and resistance of the solar cell 2. The conductive adhesive film 15a is formed on the busbar electrodes 11, and the end 3a of each tab wire 3 is formed thereon. Thus, the busbar electrodes 11 are connected to the surface 30b of the end 3a of the tab wire 3 via the conductive adhesive film 15a.

The rear surface electrode 13 is formed on the rear surface of each photoelectric conversion element 10 by using, for example, a screen printing method, a sputtering method, or the like, as an electrode made of aluminum, silver or the like. The rear surface electrode 13 is connected to the surface 30a of the end 3b of the tab wire 3 via the conductive adhesive film 15b.

In this manner, each of the solar cells 2 installed in the solar cell module 1 is mechanically connected to the tab wires 3 on both of the surface and rear surface, and is also electrically connected to an adjacent solar cell 2 via the tab wires 3.

### [Tab Wire]

As shown in Fig. 3, the tab wire 3 is formed into an elongated shape by using a ribbon-shaped copper foil having a thickness of, for example 50 to 300µm, with a gold plating, silver plating, tin plating, solder plating process or the like being carried out thereon, if necessary. On each of one of the surfaces 30a and the other surface 30b of the tab wire 3, concavo-convex portions 21 are formed in the longitudinal direction. The tab wire 3 has one of the ends 3a secured onto the busbar electrodes 11 of a solar cell 2 and connected thereto, and also has the other end 3b secured onto the rear surface electrode 13 of an adjacent solar cell and connected thereto.

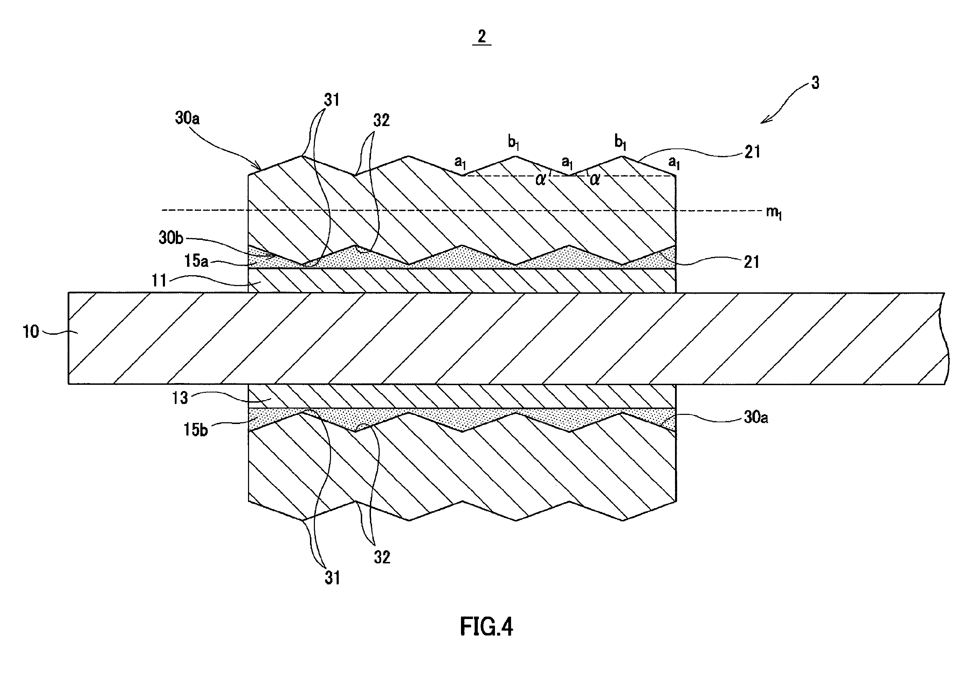

More specifically, as shown in Fig. 4, on both of the surface and the rear surface, that is, on both of the surfaces 30a and 30b, of the tab wire 3, a plurality of convex portions 31 and concave portions 32, which continue in the longitudinal direction of the tab wire 3, are alternately formed in the width direction so that concavo-convex portions 21 are formed. The concavo-convex portions 21 are formed by, for example, press-molding a ribbon-shaped copper foil that has been subjected to a plating process.

Moreover, the concavo-convex portions may be subjected to a surface treatment by using a known method. The convex portion is not limited to those having an acute angle, and may have a slight degree of roundness within a range capable of measuring its concavo-convex angle α.

Each of the tab wires 3 has a symmetric shape with respect to the surface and rear surface thereof with a center line m1 serving as a border in its cross section in the width direction. With this structure, the solar cells 2 in which the tab wires 3, each having the symmetric shape with respect to the surface and rear surface thereof, are connected the busbar electrodes 11 and the rear surface electrode 13, makes it possible to prevent a warp from occurring due to a stress distortion caused upon connections of the tab wires 3.

That is, since the tab wire 3 has the symmetric shape with respect to the surface and rear surface thereof, stresses are evenly applied onto the surface side and rear surface side of the solar cell 2 when it is connected respectively to the busbar electrodes 11 and the rear surface electrode 13 by a thermal compressing process, which will be described later. For this reason, the solar cell 2 makes it possible to minimize a difference of stresses applied to the surface on the light-receiving side and the rear surface. With this structure, since the solar cell 2 makes it possible to suppress the stress distortion caused by the shapes of the tab wires 3 on both of the surface and rear surface to the minimum level, the generation of cracks and warping can be prevented.

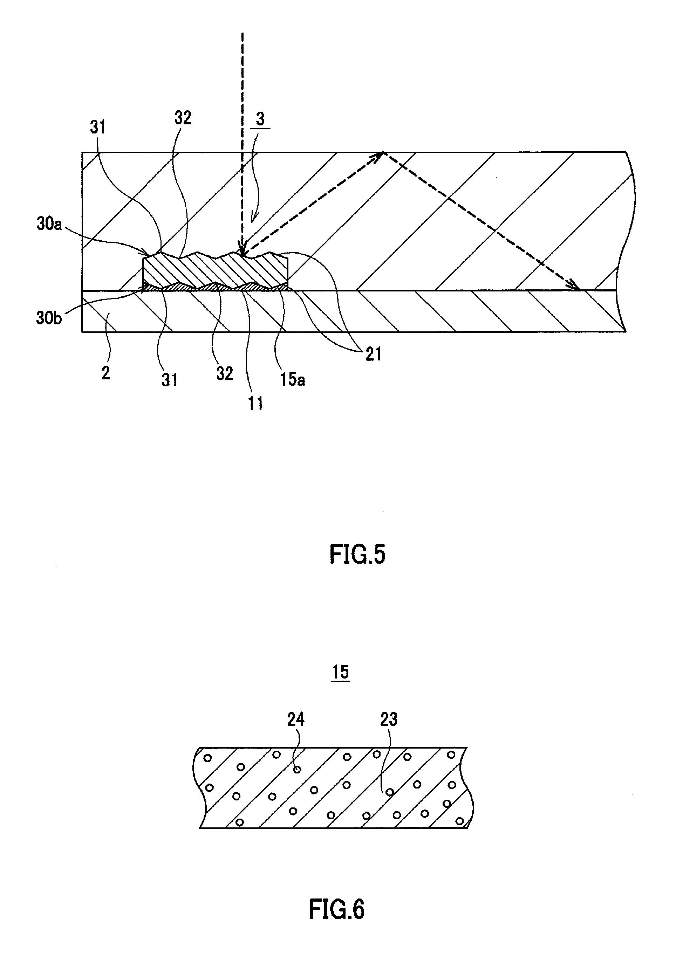

In a predetermined solar cell 2, as shown in Fig. 5, the concavo-convex portion 21 on the surface 30b of the end 3a of each tab wire 3 is connected to the busbar electrodes 11 of the solar cell 2 via the conductive adhesive film 15a. As will be described later, in the conductive adhesive film 15a, a binder resin is allowed to flow due to heating and enter a concave portion 32 of the concavo-convex portion 21. Thus, the tab wire 3 having the predetermined concavo-convex angle makes it possible to increase the connection strength relative to the busbar electrodes 11 and the rear surface electrode 13 of each solar cell 2, as will be described later.

Moreover, on the light-receiving surface side, the predetermined solar cell 2 has light, which is made incident on the concavo-convex portion 21 on the surface 30a of the end 3a of each tab wire 3, scattered by the concavo-convex portion 21, and the scattered light is reflected by the surface cover 7 made of glass or the like, and again made incident on the light-receiving surface. Thus, the solar cell 2 makes it possible to achieve a high power generation efficiency.

Moreover, the concavo-convex portion 21 on the surface 30a of the end 3b of the tab wire 3 is connected to the rear surface electrode 13 of a solar cell 2 adjacent to the predetermined solar cell 2 via the conductive adhesive film 15b. In this connection also, in the conductive adhesive film 15b, a binder resin is allowed to flow due to heating and enter a concave portion 32 of the concavo-convex portion 21 so that it becomes possible to improve the connection reliability (adhesion strength) to the rear surface electrode 13.

As described above, the tab wire 3 with which the solar cell module 1 is provided has the concavo-convex portions 21 with a predetermined convexo-concave angle formed on both of the surface and rear surface 30a and 30b. Thus, the solar cell module 1 has such a structure that in the predetermined solar cells 2, the tab wire 3 and the busbar electrodes 11, as well as the tab wire 3 and the rear surface electrode 13, are mechanically connected to each other with high connection strength, and the busbar electrodes 11 of the predetermined solar cell 2 and the rear surface electrode 13 of a solar cell 2 adjacent to the predetermined solar cell 2 are electrically connected to each other with high connection reliability.

The following description will discuss the concavo-convex angle of the concavo-convex portions 21. As shown in Fig. 4 that was previously referred to, in a cross section in the width direction of the tab wire 3, an angle, which is made by a line segment a₁b₁ formed by connecting an apex b₁ of the convex portion 31 and an apex (lowest point) a₁ of each of concave portions 32 adjacent to the convex portion 31 on the two sides and a line segment a₁a₁ formed by connecting the apexes a₁ of the concave portions 32 adjacent to the convex portion 31, is defined as the concavo-convex angle α of the tab wire 3. Here, the cross section of the tab wire 3 has the symmetric shape with respect to the surface and rear surface thereof with the center line m₁ serving as a border. For this reason, on the other surface 30b also, a concavo-convex angle α having the same value can be obtained from the convex portion 31 and the concave portions 32.

The concavo-convex angle α is preferably set to 10° or more to 50° or less, and more preferably, to 20° or more to 40° or less. By setting the concavo-convex angle α to 10° or more to 50° or less, it is possible to allow the incident light to scatter and to be reflected by the surface cover 7, and consequently to allow the solar cell module 1 to exert a light confinement effect so as to increase the power generation efficiency.

Moreover, by setting the concavo-convex angle α to 10° or more, a sufficient amount of the conductive adhesive film 15 (conductive adhesive films 15a and 15b) is allowed to flow by heating and enter the concave portion 32 of each of the concavo-convex portions 21 so that it is possible to improve the connection reliability between the tab wire 3 and the busbar electrodes 11 as well as between the tab wire 3 and the rear surface electrode 13.

Furthermore, as shown in Fig. 5, the concavo-convex portions 21 on the surface 30b of the tab wire 3 are adhered to the conductive adhesive film 15a with high adhesion strength so as to be connected to the busbar electrodes 11 of the solar cell 2. When an incident light ray is made incident on the concavo-convex portions 21 of the surface 30a, the light is scattered by the concavo-convex portions 21. Further, the scattered light is reflected by the surface cover 7 serving as a protective glass surface, and again made incident on the photoelectric conversion element 10.

In this manner, the solar cell module 1 is allowed to exert the light confinement effect to improve the power generation efficiency so that the power generation efficiency is consequently enhanced, and by allowing a sufficient amount of the conductive adhesive film 15a to enter the concave portion 32 of each concavo-convex portion 21, the connection reliability between the tab wire 3 and the busbar electrodes 11 can be improved.

### [Conductive Adhesive Film]

For example, as shown in Fig. 6, the conductive adhesive film 15 is formed by allowing a thermosetting binder resin layer 23 to contain conductive particles 24 at a high concentration. Moreover, from the viewpoint of indenting property, the conductive adhesive film 15 is preferably made to have a lowest melt viscosity of a binder resin in a range from 100 to 100000 Pa·s.

When the lowest melt viscosity of the conductive adhesive film 15 is too low, the resin tends to flow from a low press-bonding process to a main curing process to cause any connection failure or any protrusion onto the cell light receiving surface, resulting in a reduction in light receiving rate. Moreover, when the lowest melt viscosity is too high, a problem tends to occur upon pasting the film, resulting in any adverse effect to connection reliability. Additionally, the lowest melt viscosity can be measured by loading a predetermined amount of a sample to a rotary viscometer and measuring the viscosity while raising the temperature at a predetermined rate.

Although not particularly limited, as the conductive particles 24 used for the conductive adhesive film 15, examples thereof include: metal particles such as nickel, gold and copper, resin particles that are subjected to gold plating or the like, and those resin particles that are subjected to gold plating, with their outermost layer being coated with an insulating material. Moreover, by allowing flat flake-shaped metal particles to be contained as the conductive particles 24, the number of mutually overlapped conductive particles 24 is increased, making it possible to ensure good conduction reliability.

Moreover, the conductive adhesive film 15 preferably has a viscosity in a range from 10 to 10000 kPa·s, and more preferably, from 10 to 5000 kPa·s, at about normal temperature. By setting the viscosity of the conductive adhesive film 15 in the range from 10 to 10000 kPa·s, it becomes possible to prevent so-called protrusion at the time when, for example, the conductive adhesive film 15 is wound into a reel shape as a tape, as will be described later, and also to maintain a predetermined tacking strength.

Although not particularly limited as long as the above-mentioned characteristics are not impaired, the composition of a binder resin layer of the conductive adhesive film 15 preferably includes a film-forming resin, a liquid-state epoxy resin, a potential curing agent and a silane coupling agent.

The film-forming resin corresponds to a high-molecular-weight resin having an average molecular weight of 10000 or more, and from the viewpoint of a film forming characteristic, preferably, the average molecular weight thereof is set to about 10000 to 80000. As the film-forming resin, various resins, such as an epoxy resin, a modified epoxy resin, a urethane resin, a phenoxy resin and the like, may be used, and among these, from the viewpoint of film-forming state, connection reliability, etc., a phenoxy resin is preferably used.

As the liquid-state epoxy resin, not particularly limited as long as it has flowability at normal temperature, any commercially-available epoxy resin may be used. Specific examples of these epoxy resins include: naphthalene-type epoxy resins, biphenyl-type epoxy resins, phenol novolak-type epoxy resins, bisphenol-type epoxy resins, stilbene-type epoxy resins, triphenol methane-type epoxy resins, phenol aralkyl-type epoxy resins, naphthol-type epoxy resins, dicyclopentadiene-type epoxy resins and triphenyl methane-type epoxy resins. One of these may be used alone, or two kinds or more of these may be used in combination. Moreover, another organic resin, such as an acrylic resin, may be used in combination on demand.

As the potential curing agent, various curing agents, such as hot setting-type, UV-setting-type or the like curing agent, may be used. The potential curing agent is not allowed to react normally, but is activated with a certain trigger, and starts a reaction. As the trigger, heat, light, pressure or the like is used, and by making selection among these depending on the application, any of these may be used. In the case when a liquid-state epoxy resin is used, a potential curing agent made of imidazoles, amines, sulfonium salts, onium salts, or the like, may be used.

As the silane coupling agent, epoxy-based, amino-based, mercapto-sulfide-based, or ureide-based agents may be used. Among these, in the present embodiment, an epoxy-based silane coupling agent is preferably used. Thus, it is possible to improve an adhesive property on an interface between the organic material and the inorganic material.

Moreover, as another additive composition, an inorganic filler is preferably contained. When the inorganic filler is contained therein, the flowability of a resin layer upon press-bonding can be adjusted so that the particle capturing rate can be improved. As the inorganic filler, materials, such as silica, talc, titanium oxide, calcium carbonate, magnesium oxide or the like, may be used, and the kind of the inorganic filler is not particularly limited.

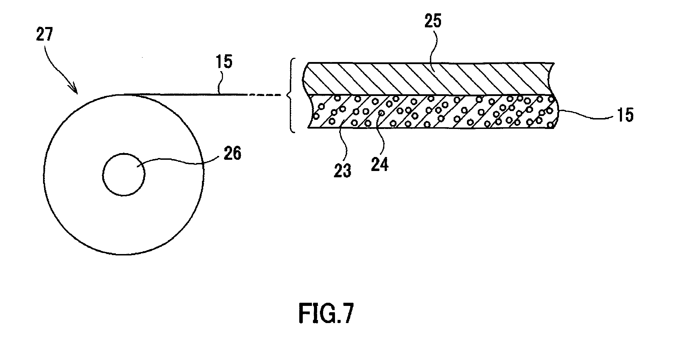

Fig. 7 is a schematic view that shows one example of a product mode of the conductive adhesive film 15. The conductive adhesive film 15 is provided with a peeling base member 25 formed on one of its surfaces, and formed into a film laminate, and this is molded into a tape shape. This tape-shaped conductive adhesive film 15 is wound around and stacked on a reel 26, with the peeling base member 25 being located on the peripheral side so that a reel member 27 is formed.

As the peeling base member 25, not particularly limited, PET (Poly Ethylene Terephthalate), OPP (Oriented Polypropylene), PMP (Poly-4-methylpentene-1), PTFE (Polytetrafluoroethylene) and the like may be used. Moreover, the conductive adhesive film 15 may have a structure in which a transparent cover film is formed on a surface opposite to the surface on which the peeling base member 25 is formed.

At this time, as the cover film to be pasted onto the binder resin layer, the aforementioned tab wire 3 may be used. By preliminarily stacking the tab wire 3 and the conductive adhesive film 15 as one integral laminate, the peeling base member 25 can be separated at the time of an actual application, and by pasting the conductive adhesive film 15 onto the busbar electrodes 11 and the rear surface electrode 13 so that the tab wire 3 can be connected to the busbar electrodes 11 and the rear surface electrode 13. Additionally, not particularly limited to the reel member shape, the conductive adhesive film 15 may be formed into, for example, a strip shape.

In the case when the conductive adhesive film 15 is provided as the reel member 27, by setting the viscosity of the conductive adhesive film 15 in a range from 10 to 10000 kPa·s, it is possible to prevent the conductive adhesive film 15 from being deformed, and consequently to maintain predetermined dimensions thereof. Moreover, even in the case when the conductive adhesive film 15 has a strip shape and two or more sheets thereof are stacked, in the same manner, it is possible to prevent the deformation, and consequently to maintain predetermined dimensions thereof.

The conductive adhesive film 15 can be produced by using, for example, the following method. First, conductive particles 24, a film-forming resin, a liquid-state epoxy resin, a potential curing agent and a silane coupling agent are dissolved in a solvent. As the solvent, toluene, ethyl acetate, or the like, or a mixed solvent of these, may be used. The resin forming solution obtained by the dissolving process is applied onto a peeling sheet, and the solvent is volatilized. Thus, the conductive adhesive film 15 is obtained.

### [Production Process]

The following description will discuss a production process of the solar cell module 1. The solar cell module 1 is formed by processes including a temporarily pasting process in which the conductive adhesive film 15 is temporarily pasted onto the busbar electrodes 11 and the rear surface electrode 13, an arranging process in which the solar cells 2 are arranged, a temporarily press-bonding process in which the tab wire 3 is thermally compressed onto the conductive adhesive film 15 at a low temperature under a low pressure so as to be disposed on the busbar electrodes 11 and the rear surface electrode 13, and a main press-bonding process in which by carrying out a thermally compressing process onto the tab wire 3, the conductive adhesive film 15 is thermally cured so that the tab wire 3 is connected to the busbar electrodes 11 as well as to the rear surface electrode 13.

First, an uncured conductive adhesive film 15 is temporarily pasted onto the busbar electrodes 11 and the rear surface electrode 13 of each of the solar cells 2 (temporarily pasting process). In the temporarily pasting process of the conductive adhesive film 15, for example, the conductive adhesive film 15 wound around the reel member 27 is transported to predetermined positions on the surface and rear surface sides of the solar cell 2, and by compressing the film using a temporarily pasting head, the conductive adhesive film 15 is temporarily pasted thereon.

By carrying out a heating process by the temporary pasting head (not shown) at such a temperature (for example, 40 to 60°C) as to allow the conductive adhesive film 15 to exert flowability, but as not to allow it to cause the main curing process for a predetermined period of time (for example, 1 to 5 seconds), the conductive adhesive film 15 is temporarily pasted on each of the solar cells 2. The solar cells 2 on each of which the conductive adhesive film 15 has been temporarily pasted are arranged in such an order as to be series-connected.

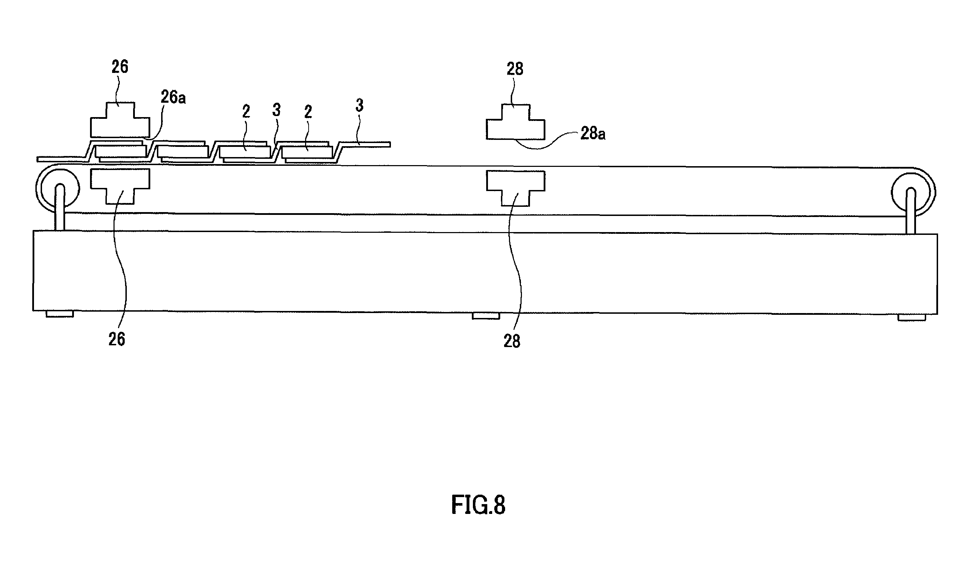

Next, onto each of the solar cells 2 that is arranged at a predetermined position opposed to a pair of upper and lower temporarily press-bonding heads 26, the tab wire 3 is temporarily press-bonded onto the conductive adhesive film 15 (temporary press-bonding process). At this time, as shown in Figs. 2 and 8, one end 3a of the tab wire 3 is temporarily press-bonded onto the busbar electrodes 11 formed on the surface of a proceeding solar cell 2 via an uncured conductive adhesive film 15a. Moreover, the other end 3b of the tab wire 3 is temporarily press-bonded onto the rear surface electrode 13 of the succeeding solar cell 2 via an uncured conductive adhesive film 15b.

In the same manner, on the busbar electrodes 11 formed on the surface of the solar cell 2 as well as on a rear surface electrode 13 of a solar cell 2 that succeeds to the solar cell 2, one of ends 3a of a tab wire 3 and the other end 3b thereof are temporarily press-bonded via uncured conductive adhesive films 15. In this manner, the adjacent solar cells 2 are mutually series-connected to one after another by using the tab wires 3.

As described above, with respect to the tab wire 3, the surface 30b on which the concavo-convex portion 21 has been formed is temporarily press-bonded onto the busbar electrodes 11 at one of the ends 3a, while the surface 20a on which the concave-convex portion 21 has been formed is temporarily press-bonded onto the rear surface electrode 13 at the other end 3b.

In the temporarily press-bonding process, the tab wires 3 are temporarily press-bonded by the temporarily press-bonding head 26. The temporarily press-bonding head 26 is heated to such a temperature (for example, 70 to 100°C) as not to allow the curing reaction of the conductive adhesive film 15 to proceed, and the tab wire 3 is compressed by its compressing surface 26a for a predetermined period of time. Therefore, the conductive adhesive film 15 allows its binder resin to exert flowability and also to have high adhesion strength so that each tab wire 3 is temporarily fixed onto the busbar electrodes 11 as well as onto the rear surface electrode 13.

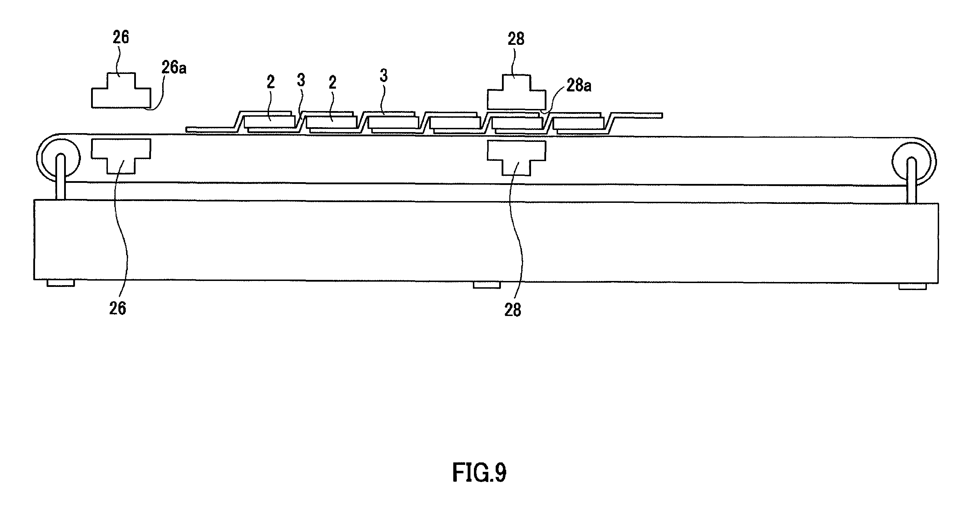

Next, as shown in Fig. 9, the plural solar cells 2 on which the tab wires 3 have been temporarily fixed are transported right below a pair of upper and lower heating press heads 28, and after having been supported thereon, the tab wires 3 are subjected to a main press-bonding process onto the respective busbar electrodes 11 and the rear surface electrodes 13 of the solar cells 2 by pressing surfaces 28a of the heating press heads 28 so that the conductive adhesive film 15 is cured (main press-bonding process).

At this time, with respect to the plural solar cells 2, by raising/lowering the paired heating press heads 28 formed on the upper and lower sides in synchronism with each other, the tab wire 3 of the proceeding solar cell 2 is compressed with a predetermined pressure (for example, about 3 MPa to 12 MPa). The heating press heads 28 are heated to a predetermined temperature (for example, about 180 to 220°C) at which the conductive adhesive film 15 is cured. Therefore, the conductive adhesive film 15 has its binder resin thermally cured so that the tab wire 3 and the busbar electrodes 11 or the rear surface electrode 13 are connected to each other electrically as well as mechanically.

By this main press-bonding process, the conductive adhesive film 15 is allowed to enter the concave portion 32 of each of the concavo-convex portions 21 having a concavo-convex angle α of 10 to 50° so that the connection reliability with the busbar electrodes 11 and the rear surface electrode 13 can be improved. Moreover, by improving the particle capturing rate of the concave portion 32, it becomes possible to obtain high conduction reliability.

After the tab wire 3 has been mainly press-bonded to the proceeding solar cell 2 by the heating press heads 28, the paired heating press heads 28 are separated from the tab wire 3, and the succeeding solar cell 2 is transported right below the paired heating press heads 28. In this manner, the solar cells 2 are transported right below the heating press heads 28 one by one so that the tab wires 3 are successively adhered to the busbar electrodes 11 and the rear surface electrode 13, and are also series-connected to adjacent solar cells 2.

In the production process of the solar cell module 1, in order to connect each of the busbar electrodes 11 and the rear surface electrode 13 to the tab wire 3 by the conductive adhesive film 15, either of Al and Ag may be used as the rear surface electrode 13 of the solar cell 2; however, by using an Al rear surface collector electrode as the rear surface electrode 13, it becomes not necessary to prepare a conventionally-used Ag electrode for use in solder connection, and consequently, the production process of the solar cell can be shortened so that this method is advantageous from the production engineering point of view.

In the production process of the solar cell module 1, the tab wire 3 having the concavo-convex portions 21 on both of the surfaces in this manner is respectively connected to the busbar electrodes 11 and the rear surface electrode 13 via a thermosetting resin. By applying the same pressure to the tab wire 3 having the same shape on both of the surfaces from the two surface sides of the tab wire 3, it becomes possible to minimize the stress distortion in the solar cell 2 and consequently to suppress cracks and warping in the solar cell 2.

Moreover, since the solar cell module 1 is provided with the tab wire 3 having the symmetric shape with respect to the surface and rear surface thereof, with the concavo-convex portions 21 formed on both of the surface and rear surface, it becomes possible to suppress a stress distortion caused on the surface and rear surface of the solar cell 2 upon simultaneously connecting both of the surface and rear surface of the solar cell 2, and consequently to prevent cracks and warping from occurring in the solar cell 2. For example, even in the case when the solar cell 2 is very thin, these effects derived from suppressing the stress distortion can be obtained.

Moreover, by setting the concavo-convex angle α in each of the concave-convex portions 21 of the tab wire 3 to 10 to 50°, the solar cell module 1 is allowed to exert a light confinement effect by utilizing scattered light and consequently to increase the power generation efficiency, and also achieves stable conduction reliability and connection reliability on the surface electrode side and the rear surface electrode side respectively.

Although the present invention has been described above concretely by way of embodiments thereof, it is needless to say that the invention is not limited to the above embodiments, but that various changes may be made within the scope not departing from the gist of the invention.

In the above-mentioned embodiments, by using the conductive adhesive film 15 as the adhesive resin material, the busbar electrodes 11 and the rear surface electrode 13 are respectively connected to the tab wire 3; however, another adhesive resin material may be used. In the case when a non-conductive adhesive film is used as the adhesive resin material, the convex portions 31 of the concavo-convex portions 21 of the tab wire 3 are directly made in contact with the busbar electrodes 11 and the rear surface electrode 13 respectively so that electrical conduction is prepared. Moreover, in place of forming the conductive film, a paste-state adhesive agent, such as a conductive paste, a non-conductive paste or the like, may be applied with an appropriate thickness. By applying the conductive paste or the non-conductive paste with an appropriate thickness, the same functions and effects as those of the conductive adhesive film 15 and the non-conductive adhesive film can be obtained.

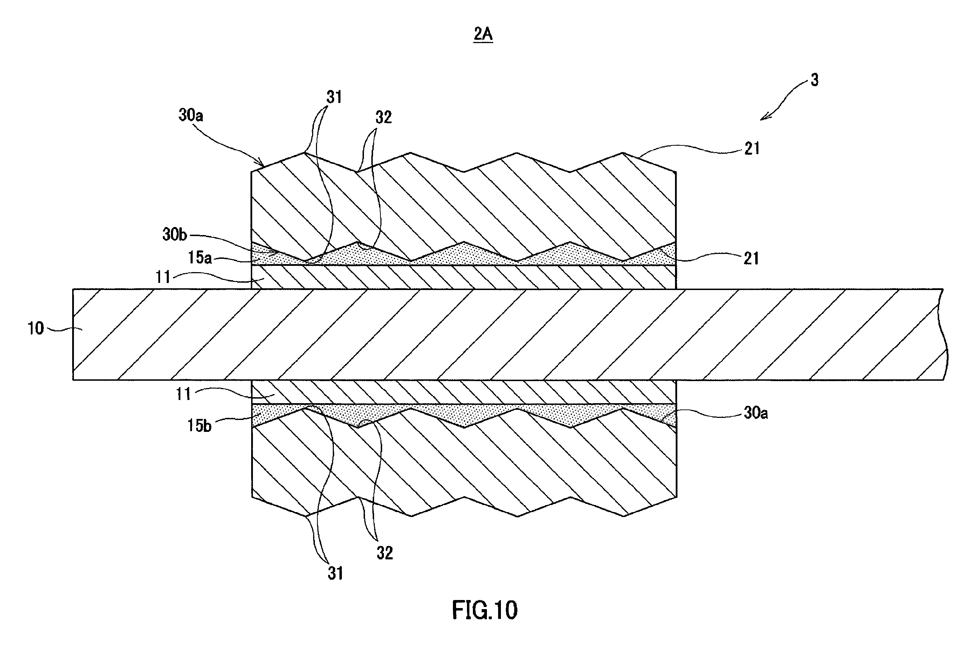

Moreover, the above-mentioned embodiments are explained by exemplifying the solar cell module 1 provided with the solar cell 2 of a one-surface light-receiving type; however, not limited to this, for example, as shown in Fig. 10, a solar cell module provided with a solar cell 2A of a two-surface light-receiving type may be used. The solar cell 2A is provided with finger electrodes 12 and busbars 11 in place of the rear surface electrode 13. Furthermore, a solar cell module provided with the solar cell 2A is designed to have a surface cover 7 in place of the back sheet 8.

In this manner, in the case of the solar cell module provided with the two-surface light-receiving type solar cell 2A also, by using the tab wire 3 having the symmetric shape with respect to the surface and rear surface thereof, it becomes possible to suppress a stress distortion caused on the surface side and rear surface side of the solar cell 2 to the minimum upon simultaneously connecting both of the surface and rear surface of the solar cell 2A with the tab wire 3, and consequently to prevent cracks and warping from occurring in the solar cell 2. Moreover, on the surface electrode side (busbar electrodes 11 and finger electrodes 12 side) as well as on the rear surface electrode 13 side, stable conduction reliability and connection reliability can be achieved. Furthermore, by preparing the tab wire 3 having concavo-convex portions 21 formed on two surface sides, it becomes possible to further improve the power generation efficiency.

### Examples

### [Examples]

Next, the following description will discuss specific examples of the present invention. Additionally, the scope of the present invention is not intended to be limited by the following examples. In the present examples, tab wires, as shown in the following examples 1 to 5 and comparative examples 1 to 5, are connected to solar cells 2 as indicated by the previously mentioned Fig. 2.

### (Example 1)

First, a solar cell of a one-surface light-receiving type was prepared. On each of a busbar electrode and a rear surface electrode installed in this solar cell, an uncured conductive adhesive film (trade name: SP100 Series, made by Sony Chemical & Information Device Corporation) was temporarily pasted by heating and compressing by the use of a temporary pasting head at a heating temperature of 180°C under a pressure of 2MPa for 15 seconds. Next, on the conductive adhesive film temporarily pasted on the busbar electrode of the solar cell as well as on the conductive adhesive film temporarily pasted on the rear surface of the solar cell, a tab wire with concavo-convex portions having a concavo-convex angle α (= 10°) formed on both of the surfaces thereof was respectively press-bonded. This press-bonding process was carried out by heating and compressing by the use of a press-bonding head at 180°C under a pressure of 2MPa for 15 seconds.

### (Example 2)

The same processes as those of example 1 were carried out except that in place of the tab wire of example 1, a tab wire with concavo-convex portions having a concavo-convex angle α (= 20°) formed on both of the surfaces thereof was used.

### (Example 3)

The same processes as those of example 1 were carried out except that in place of the tab wire of example 1, a tab wire with concavo-convex portions having a concavo-convex angle α (= 30°) formed on both of the surfaces thereof was used.

### (Example 4)

The same processes as those of example 1 were carried out except that in place of the tab wire of example 1, a tab wire with concavo-convex portions having a concavo-convex angle α (= 40°) formed on both of the surfaces thereof was used.

### (Example 5)

The same processes as those of example 1 were carried out except that in place of the tab wire of example 1, a tab wire with concavo-convex portions having a concavo-convex angle α (= 50°) formed on both of the surfaces thereof was used.

### (Comparative Example 1)

The same processes as those of example 1 were carried out except that in place of the tab wire of example 1, a tab wire with concavo-convex portions having a concavo-convex angle α (= 5°) formed on both of the surfaces thereof was used.

### (Comparative Example 2)

The same processes as those of example 1 were carried out except that in place of the tab wire of example 1, a tab wire with concavo-convex portions having a concavo-convex angle α (= 60°) formed on both of the surfaces thereof was used.

### (Comparative Example 3)

In place of the tab wire of example 1, a tab wire with concavo-convex portions having a concavo-convex angle α (= 30°) formed on one of the surfaces thereof was used. In the tab wire connected to the busbar electrode, the surface on which the concavo-convex portions were formed was used as the light-receiving surface side, and in the tab wire connected to the rear surface electrode, the surface on which the concavo-convex portions were formed was made face to face with the rear surface electrode ("one surface (1)" in "Table 1"). Except for the above-mentioned points, the same processes as those of example 1 were carried out.

### (Comparative Example 4)

In place of the tab wire of example 1, a tab wire with concavo-convex portions having a concavo-convex angle α (= 30°) formed on one of the surfaces thereof was used. In the tab wire connected to the busbar electrode, the surface on which the concavo-convex portions were formed was made face to face with the busbar electrode, and in the tab wire connected to the rear surface electrode, a surface opposite to the surface on which the concavo-convex portions were formed was made face to face with the rear surface electrode ("one surface (2)" in "Table 1"). Except for the above-mentioned points, the same processes as those of example 1 were carried out.

### (Comparative Example 5)

The same process as those of example 1 were carried out except that in place of the tab wire of example 1, a tab wire having a planar shape without any concavo-convex portions formed on any of the two surfaces was used.

### <Evaluation of Power Generation Efficiency>

The power generation efficiency (%) per solar cell after the tab wire had been connected thereto was measured by using a solar simulator (Type: PVS1116i-M(JIS C8913) made by Nisshinbo Mechatronics Inc.). When the power generation efficiency was 16% or more, this case was evaluated as ⊚, when it was in a range from 15.75 to 16%, this case was evaluated as ○, when it was in a range from 15.6 to 15.75%, this case was evaluated as Δ, and when it was 15.6% or less, this case was evaluated as ×. The evaluation results are shown in [Table 1].

### <Evaluation of Connection Reliability>

Moreover, 90-degree peeling tests (JIS K6854-1) were carried out in which the tab wire was separated from each of the conductive adhesive films respectively bonded to the busbar electrode and the rear surface electrode in a direction of 90° so that the peeling strength (N/cm) was measured. Based upon the measured peeling strength, the connection reliability between the tab wire and the busbar electrode as well as between the tab wire and the rear surface electrode was evaluated. When the peeling strength was 10 N/cm or more, this case was evaluated as ⊚, when it was in a range from 8 to 10 N/cm, this case was evaluated as ○, when it was in a range from 6 to 8 N/cm, this case was evaluated as Δ, and when it was 6 N/cm or less, this case was evaluated as ×; thus, the connection reliability was evaluated. The evaluation results are shown in [Table 1].

### <Evaluation of Amount of Warping>

In a state where a solar cell was put on a plane (with a convex surface caused by warping being put on the lower side), the maximum value of the height (mm) from the plane on each of the four corners of the solar cell was measured as an amount of warping (mm). When the amount of warping was 1 mm or less, this case was evaluated as ○, when it was in a range from 1 mm or more to 2.5 mm or less, this case was evaluated as Δ, and when it was 2.5 mm or more, this case was evaluated as ×; thus, the evaluations were carried out. The evaluation results are shown in [Table 1].

### <Total Evaluation>

In the case when among the respective evaluation items of the power generation efficiency, the connection reliability and the amount of warping, there were no evaluation results of × so that the resulting products were put into practical use without causing any problems, this case was ranked as total evaluation of ○, while in the case when among the respective evaluation items, there was any one of evaluation result of ×, this case was ranked as total evaluation of ×. The total evaluation results are shown in [Table 1].

**[Table 1]**

| | Example 1 | Example 2 | Example 3 | Example 4 | Example 5 | Comparative Example 1 | Comparative Example 2 | Comparative Example 3 | Comparative Example 4 | Comparative Example 5 |
|---|---|---|---|---|---|---|---|---|---|---|
| Layout of concavo-convex portions in tab wire | Two surfaces | Two surfaces | Two surfaces | Two surfaces | Two surfaces | Two surfaces | Two surfaces | One surface (1) | One surface (2) | None |
| Concavo-convex angle α (° ) | 10 | 20 | 30 | 40 | 50 | 5 | 60 | 30 | 30 | - |
| Power generation efficiency | Δ | ○ | ⊚ | ○ | Δ | × | × | ⊚ | × | × |
| Connection reliability | Δ | ○ | ○ | ⊚ | ⊚ | × | ⊚ | Light-receiving surface × | Rear surface × | × |
| Amount of warping | ○ | ○ | ○ | ○ | ○ | ○ | ○ | × | × | ○ |
| Total evaluation | ○ | ○ | ○ | ○ | ○ | × | × | × | × | × |

As shown in [Table 1], in examples 1 to 5 in which the concavo-convex angle α was set to 10° or more to 50° or less, since an incident light ray was made incident on the concavo-convex portions having the concavo-convex angle α, scattered light having a desirable scattering angle could be obtained, and the resulting scattered light made it possible to exert a light confinement effect so that a high value in the power generation efficiency could be obtained. In particular, in example 3 where the concavo-convex angle α was set to 30°, the light confinement effect was most preferably exerted so that the highest power generation efficiency was obtained.

Moreover, in examples 1 to 5, since the concavo-convex angle α was set to 10° or more to 50° or less, the filled amount of the binder resin of the conductive adhesive film to be allowed to flow by heating and enter the concave portion became a sufficient amount so that the connection reliability between the tab wire and the busbar electrode as well as between the tab wire and the rear surface electrode became better. In particular, in examples 4 and 5 where the concavo-convex angle α was set to 40° or more, a more binder filling amount was obtained in the concave portion so that high connection reliability could be obtained.

Moreover, in examples 1 to 5, since the tab wire having the symmetric shape with respect to the surface and rear surface was installed, it became possible to suppress the generation of warping to a minimum level.

As described above, in examples 1 to 5, based upon the evaluation results of the power generation efficiency, the connection reliability and the amount of warping, it was possible to obtain the total evaluation results to ensure that the resulting products could be put into practical use without causing any problems.

In particular, in examples 2 to 4, since the concavo-convex angle α was set to 20° or more to 40° or less, the scattering angle of the incident light ray could be set to a more desirable value so that a higher value was obtained in the power generation efficiency. Moreover, since the concavo-convex angle was set to 20°, the filled amount of the binder resin of the conductive adhesive film to be allowed to flow by heating and enter the concave portion was further increased so that high connection reliability was obtained.

On the other hand, in comparative examples 1, 2, 4 and 5, the power generation efficiency became a low value. It was considered that this was because of the facts that in comparative example 1, the concavo-convex angle α of the concavo-convex portions formed on the two surfaces of the tab wire was too small, that in comparative example 2, the concavo-convex angle α of the concavo-convex portions formed on the two surfaces of the tab wire was too large, that in comparative example 4, the surface having a planar shape of the tab wire was formed as the light-receiving surface side, and that in comparative example 5, the two surfaces of the tab wire were formed into a planar shape (concavo-convex angle α = 0°), with the result that in any of these cases, the light confinement effect by the use of scattered light was not sufficiently exerted.

Moreover, in comparative examples 1 and 3 to 5, the connection reliability between the tab wire and the busbar electrode as well as between the tab wire and the rear surface electrode was not preferable. It was considered that this was because of the fact that in comparative example 1, the concavo-convex angle α was too small, with the result that the filling amount of the binder resin of the conductive adhesive film to be allowed to flow by heating and enter the concave portions was not sufficient to cause inferior connection reliability.

Furthermore, in comparative example 3, since the surface on the connection side of the tab wire to the busbar electrode on the light-receiving surface side was formed into a planar shape, the tab wire surface having this planar shape completely failed to obtain a sufficient filling amount of the binder resin on the tab wire surface having the planar shape to cause inferior connection reliability between the tab wire and the busbar electrode on the light-receiving surface side. In comparative example 4, since the surface on the connection side of the tab wire to the rear surface electrode on the rear surface side was formed into a planar shape, the tab wire surface having this planar shape completely failed to obtain a sufficient filling amount of the binder resin to cause inferior connection reliability between the tab wire on the rear surface side and the rear surface electrode.

Moreover, in comparative example 5, since the two surfaces of the tab wire were formed into a planar shape, the tab wire surface having this planar shape completely failed to obtain a sufficient filling amount of the binder resin to cause inferior connection reliability on both of the busbar electrode side and the rear surface electrode side.

Furthermore, in comparative examples 3 and 4, it was considered that since connection was made to the tab wire having an asymmetric shape with respect to the surface and rear surface thereof, a stress distortion occurred between the busbar electrode side and the rear surface electrode side of the solar cell upon connection of the tab wire, with the result that a large amount of warping was caused.

### Reference Signs List

1...soar cell module, 2...solar cell, 3...tab wire, 4...string, 5...matrix, 10... photoelectric conversion element, 11...busbar electrode, 12...finger electrode, 13...rear surface electrode, 15...conductive adhesive film, 21...concavo-convex portion.

## Claims

1. A solar cell module comprising:
a plurality of solar cells in which a surface electrode of a predetermined one of the solar cells is connected to a rear surface electrode of another one of the solar cells that is adjacent to one side of the predetermined solar cell via a tab wire,
wherein the tab wire has two surface and rear surface on which concavo-convex portions, which are composed of a plurality of convex portions and concave portions that respectively continue in a longitudinal direction, are alternately formed in a width direction, with one end thereof being connected to the surface electrode and the other end being connected to the rear surface electrode, via an adhesive resin material, and
wherein a concavo-convex angle, which is made by a line segment formed by connecting an apex of the convex portion and an apex of each of concave portions adjacent to the convex portion and a line segment formed by connecting the apexes of the concave portions adjacent to the two sides of the convex portion, is set to 10° or more to 50° or less.

2. The solar cell module according to claim 1, wherein the concavo-convex angle is set to 20° or more to 40° or less.

3. The solar cell module according to claim 1 or 2, wherein the adhesive resin material is a conductive adhesive film containing conductive particles or a non-conductive adhesive film containing no conductive particles.

4. A method of manufacturing a solar cell module that comprises a plurality of solar cells in which a surface electrode of a predetermined one of the solar cells is connected to a rear surface electrode of another one of the solar cells that is adjacent to one side of the predetermined solar cell via a tab wire, comprising the step of:
press-bonding the tab wire respectively onto the surface electrode and the rear surface electrode of the solar cell via an adhesive resin material,
wherein the tab wire has two surface and rear surface on which concavo-convex portions, which are composed of a plurality of convex portions and concave portions that respectively continue in a longitudinal direction, are alternately formed in a width direction,
wherein a concavo-convex angle, which is made by a line segment formed by connecting an apex of the convex portion and an apex of each of concave portions adjacent to the convex portion and a line segment formed by connecting the apexes of the concave portions adjacent to the two sides of the convex portion, is set to 10° or more to 50° or less, and
wherein in the press-bonding step, one end of the tab wire is connected to the surface electrode and the other end of the tab wire is connected to the rear surface electrode respectively, via the adhesive resin material.
